Europäisches Patentamt

European Patent Office

Office européen des brevets

(19)

(11) Veröffentlichungsnummer: **0 241 662**

**A2**

(12) **EUROPÄISCHE PATENTANMELDUNG**

(21) Anmeldenummer: **87101906.3**

(22) Anmeldetag: **11.02.87**

(51) Int. Cl.4: **H01L 29/08** , H01L 29/74

(30) Priorität: **12.04.86 DE 3612367**

(43) Veröffentlichungstag der Anmeldung:
**21.10.87 Patentblatt 87/43**

(84) Benannte Vertragsstaaten:
**CH DE FR GB LI SE**

(71) Anmelder: **Licentia Patent-Verwaltungs-GmbH**
**Theodor-Stern-Kai 1**
**D-6000 Frankfurt/Main 70(DE)**

(72) Erfinder: **Schlangenotto, Heinrich, Dr.**
**Jahnstrasse 34**
**D-6078 Neu-Isenburg(DE)**
Erfinder: **Nowak, Wolf-Dieter**
**Passavantstrasse 7**
**D-6000 Frankfurt/Main 70(DE)**
Erfinder: **Berg, Hermann**
**Zum Kohlwalfeld 6**
**D-6239 Eppstein 2(DE)**

(74) Vertreter: **Erbacher, Alfons et al**
**AEG-Telefunken Theodor-Stern-Kai 1**
**D-6000 Frankfurt/Main 70(DE)**

(54) **Abschaltbarer Thyristor.**

(57) Die Erfindung bezieht sich auf einen gateabschaltbaren Thyristor, welcher je Einheitszelle einen kathodenseitigen Emitterstreifen und zwei anodenseitige beabstandete Emitterstreifen aufweist, die sich in ihrer Lage mit dem Rand des kathodenseitigen Emitterstreifens überlappen. Bei einem derartigen GTO-Thyristor nimmt der maximal abschaltbare Anodenstrom mit steigender Spannungsanstiegsgeschwindigkeit beim Abschalten stark ab, da im sich in der Mitte unter dem kathodenseitigen Emitterstreifen befindenden nichtregenerativen Transistorbereich zu hohe elektrische Felder auftreten. Eine Reduzierung der im nichtregenerativen Transistorbereich auftretenden Feldstärke und damit eine Reduzierung der Abnahme des maximal abschaltbaren Anodenstromes wird erfindungsgemäß dadurch erzielt, daß zwischen den beiden anodenseitigen Emitterstreifen (24) eine p-Zone (25) zur dynamischen Begrenzung des elektrischen Feldes angeordnet ist, die in geringerem Maß als die benachbarten Emitterstreifen (24) und im wesentlichen nur während des Abschaltens von hohen Strömen Löcher injiziert.

Figur 4

## Abschaltbarer Thyristor

Die Erfindung bezieht sich auf einen abschaltbaren Thyristor nach dem Oberbegriff des Patentanspruchs 1.

Es ist bekannt, daß beim Abschalten eines durch negativen Steuerstrom abschaltbaren Thyristor (GTO-Thyristor) eine Konzentration des Stroms unter der Mitte der kathodenseitigen Emitterstreifen stattfindet (IEEE Trans. Electron Devices ED-13, July 1966, S.590).

Dieser Stromzusammenschnürung beim Abschalten des Thyristors kann dadurch entgegengewirkt werden, indem die anodenseitige p-Emitterzone in streifenförmige Bereiche in der Mitte unter den zugehörigen kathodenseitigen n-Emitterstreifen unterbrochen und die n-Hauptbasiszone dort mit der anodenseitigen p-Emitterzone kurzgeschlossen wird (DE-OS 25 38 042).

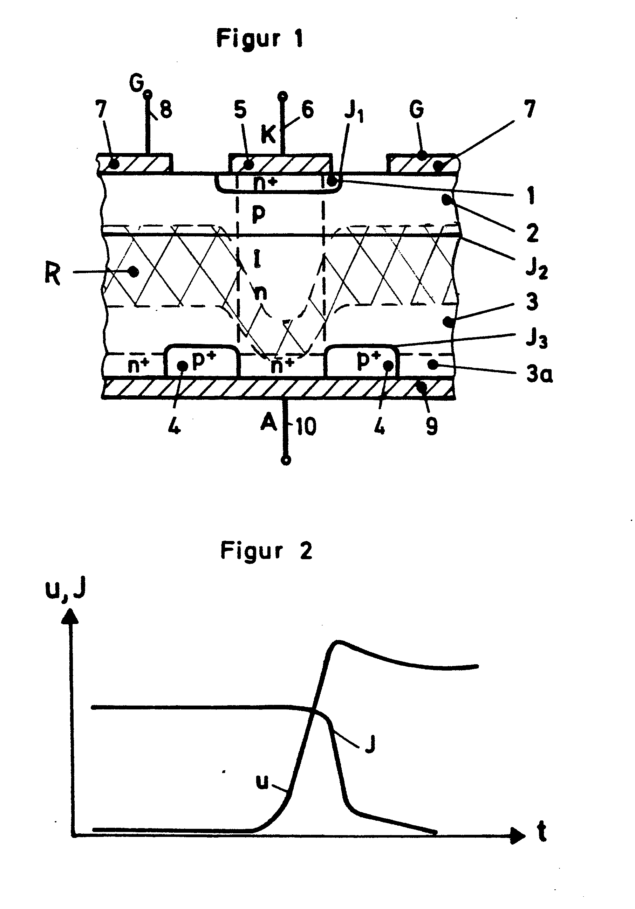

Durch diese Anodenshortung ist zusätzlich eine geeignete Einstellung des effektiven Stromverstärkungsfaktors $\alpha_{pnp}$ des anodenseitigen Teiltransistors und damit der Abschalteigenschaften möglich, ohne mit Rekombinationszentren zu dotieren zu müssen. In Fig. 1 ist eine bekannte Ausbildung einer Einheitszelle eines derartigen GTO-Thyristors dargestellt, die aus einem kathodenseitigen $n^+$-Emitterstreifen 1, einer p-Steuerbasiszone 2, einer n-Hauptbasiszone 3 mit einer hochdotierten $n^+$-Teilzone 3a und zwei anodenseitigen $p^+$-Emitterstreifen 4 gebildet ist; die p-Steuerbasiszone 2 ist teilweise an die Oberflächenebene des $n^+$-Emitterstreifens 1 geführt. Zwischen dem $n^+$-Emitterstreifen 1 und der p-Steuerbasiszone 2 befindet sich ein $n^+$p-Übergang $J_1$, zwischen der p-Steuerbasiszone und der n-Hauptbasiszone 3 befindet sich ein pn-Übergang $J_2$ und zwischen der n-Hauptbasiszone 3 und den $p^+$-Emitterstreifen 4 befindet sich ein $np^+$-Übergang $J_3$. Der $n^+$-Emitterstreifen 1 ist auf seiner Oberfläche mit einer metallischen Kontaktierungsschicht 5 (Kathode K) und einem Stromzuführungsanschluß 6 und die p-Steuerbasiszone 2 auf ihrer freiliegenden Oberfläche mit metallischen Kontaktierungsschichten 7 (Gate G) und einem Steueranschluß 8 versehen; die $p^+$-Emitterstreifen 4 und die an die anodenseitige Oberfläch geführte Teilzone 3a der n-Hauptbasiszone 3 sind mit einer gemeinsamen metallischen Kontaktierungsschicht 9 (Anode A) und einem Stromzuführungsanschluß 10 versehen.

In der Mitte unter dem kathodenseitigen $n^+$-Emitterstreifen 1 befindet sich eine nicht regnerative $n^+pnn^+$-Transistorstruktur I, die eine zu starke Konzentration des Anodenstroms in diesen Teil hinein beim Abschalten des Thyristors verhindern soll. Um durch die Shortung des anodenseitigen Emitters 4 auch eine geeignete Einstellung des effektiven Stromverstärkungsfaktors $\alpha_{pnp}$ des Teiltransistors 4, 3, 2 und damit der Abschalteigenschaften zu erreichen, ohne mit Rekombinationszentren zu dotieren, ist eine Breite für die anodenseitigen $p^+$-Emitterstreifen 4 erforderlich, die kleiner als der übliche Abstand der kathodenseitigen $n^+$-Emitterstreifen 1 ist, so daß auch in der mittleren Region unter dem Gate G der $p^+$-Emitter 4 ausgespart ist. Durch die Anodenshortung lassen sich bei Einstellung annähernd vergleichbarer Sperr-, Zünd-und Durchlaßeigenschaften die Abschaltverluste,verglichen mit GTO-Thyristoren, welche mit Rekombinationszentren dotiert sind, verringern. Eine Begrenzung für den maximal abschaltbaren Anodenstrom ergibt sich dadurch, daß der Querspannungsabfall in der p-Steuerbasiszone 2 von der Mitte der $n^+$-Emitterstreifen 1 bis zum Rand maximal gleich der Durchbruchspannung $U_{Br}$ des $n^+$p-Übergangs $J_1$ zwischen der p-Steuerbasiszone 2 und dem $n^+$-Emitterstreifen 1 sein kann; daraus folgt die Bedingung

$$J_{TCM}/L = \chi G_{off} U_{Br}/(\rho_s b), \qquad (1)$$

wobei $\rho_s$ der Schichtwiderstand der p-Steuerbasiszone 2 unter dem $n^+$-Emitterstreifen 1, b die Breite des $n^+$-Emitterstreifens 1, $G_{off} = J_A/J_G$ die Abschaltverstärkung und L die Gate-und Emitterrandlänge bedeuten; der Faktor $\chi$ ist bei homogener vertikaler Stromdichte gleich 4, erniedrigt sich aber im Grenzfall extremer Stromzusammenschnürung beim Abschalten auf den Wert 2.

Es wurde nun aber gefunden, daß GTO-Thyristoren im allgemeinen schon beim Abschalten wesentlich kleinere Ströme als nach der Bedingung (1) berechnet, zerstört werden. Der ohne Zerstörung abschaltbare Anodenstrom nimmt außerdem mit steigender Spannungsanstiegsgeschwindigkeit dU/dt beim Abschalten stark ab, was in der Bedingung (1) nicht zum Ausdruck kommt. Die Spannungsanstiegsgeschwindigkeit ist um so größer, je kleiner die Kapazität des Kondensators der üblicherweise benutzten Abschaltentlastungsbeschaltung ist (Snubber-Kondensator). Das gilt insbesondere für den GTO-Thyristor nach Fig. 1, welcher die erwähnte Maßnahme zur Verringerung der Stromzusammenschnürung aufweist.

Es wurde weiter gefunden, daß beim GTO-Thyristor nach Fig. 1 der maximal abschaltbare Anodenstrom beim Abschalten gegen hohe Spannungen mit hohem dU/dt dadurch reduziert wird, daß in dem nichtregenerativen, gestrichelt angedeuteten Transistorbereich I des GTO-Thyristors zu hohe elektrische Felder auftreten. Diese werden dadurch verursacht, daß bei schon angestiegener Spannung die Stromdichte j in diesem Transistorbereich I noch sehr hoch ist, beispielsweise 10 000 A/cm², da eine Stromkonzentration auch durch die anodenseitige Shortung nicht ganz vermieden wird; und zwar wird der Strom im anodenseitigen Teil der n-Hauptbasiszone 3 über den n⁺-Emitterstreifen 1 fast ausschließlich durch Elektronen geführt, daher ist die Elektronenkonzentration dort nach der Beziehung

$$n \geq j_n/(qv_n) \qquad (2)$$

relativ hoch, wobei q die Elementarladung und $v_n$ die Sättigungs geschwindigkeit der Elektronen bezeichnen. Bereits bei j = 1 000 A/cm² beträgt n danach mindestens $6.10^{14}/cm^3$. Da die Ladung der Elektronen weder durch die Dotierungskonzentration $N_D^+$ an Donatoren, die beispielsweise $7.10^{13}/cm^3$ beträgt, noch durch Löcher kompensiert wird, hat der Elektronenstrom also eine hohe negative Raumladung zur Folge. Entsprechend der Poisson-Gleichung

$$dE/dx = \rho/\epsilon\epsilon \qquad (3)$$

ergibt sich daraus ein Anstieg der elektrischen Feldstärke zur Anode A hin, im Gegensatz zum stationären Fall, welcher nach dem Abschalten erreicht wird. Wie aus Fig. 1 ersichtlich, befindet sich die Raumladungszone R im nichtregenerativen Transistorbereich I daher in der Umgebung des n⁺n-Übergangs zwischen der anodenseitigen n⁺-Zone 3a und der n-Basiszone 3, während sie sich in den benachbarten Bereichen, wie nach dem Abschalten allgemein, in der Umgebung des pn-Übergangs $J_2$ findet, weil diese Bereiche nur noch wenig Strom führen und außerdem zum Teil eine Vier-Schichtenstruktur aufweisen.

Da die negative Raumladung bei hohen Strömen wesentlich größer ist als die positive im stationären Fall

$$-\rho_{dyn} = qn \gg qN_D^+ = \rho_{stat}'$$

ist auch der negative Feldstärkegradient und damit der Maximalwert der Feldstärke bei gegebener Spannung wesentlich größr als im stationären Fall; somit wird die kritische Feldstärke $E_{cr}'$ die zum Lawinendurchbruch führt, während des Abschaltens schon bei relativ kleinen Spannungen erreicht. Dies führt beim GTO-Thyristor nach Fig. 1 zur Begrenzung des abschaltbaren Stroms und der Spannungsanstieggeschwindigkeit dU/dt beim Abschalten. Eine Verringerung des gegenseitigen Abstandes der anodenseitigen p⁺-Emitterstreifen 4 hat eine teilweise Kompensation der negativen Raumladung durch Löcher in dem mittleren Bereich und damit die erwähnte Reduzierung der Feldstärkeüberhöhung zur Folge; jedoch wird die Stromzusammenschnürung in diesem Bereich dann wieder größer. Insbesondere geht aber ein anderer Vorteil verloren, den eine stark zum Gate G verschobene Lage der anodenseitigen p⁺-Emitterstreifen 4 beim Abschalten hat; dieser Vorteil besteht darin, daß die Injektion von Löchern durch die n⁺-Emitterstreifen 4 bei Anlegen eines negativen Steuerstroms schneller unterbunden wird. In der kurzgeschlossenen Diodenstruktur aus p⁺-Emitterstreifen 4, n-Hauptbasiszone 3, n⁺-Teilzone 3a und Anodenkontaktierung 9 fließt dann sogar ein Kurzschlußstrom in Rückwärtsrichtung durch den p⁺-Emitter 4 und die Kontaktierung 9 zur n⁺-Teilzone 3a. Dieser Stromanteil, der keinen Beitrag zum äußeren Anodenstrom, dem Schweifstrom, liefert, trägt dagegen zum Ausräumen der Ladungsträger bei, beschleunigt also den Abschaltvorgang.

Aus der EP-OS 0066 721 ist es bereits bekannt, eine Erhöhung des zulässigen dU/dt-Wertes beim Abschalten, d. h. eine Verkleinerung der notwendigen RCD-Snubber-Beschaltung zu erzielen, ohne daß der abschaltbare Strom und die Sustaining-Spannung, gegen die abgeschaltet werden kann, zurückgenommen werden muß. Um dies zu erreichen, wird beim bekannten GTO-Thyristor die Dicke der n-Hauptbasiszone vergrößert; eine wesentliche Erhöhung der Dicke der n-Hauptbasiszone hat jedoch den Nachteil, daß der Schweifstrom und die Schweifzeit und damit die Schaltverluste gegenüber einem normalen, mit Snubber betriebenen GTO-Thyristor stark erhöht sind.

Der Erfindung liegt die Aufgabe zugrunde, einen abschaltbaren Thyristor der durch den Oberbegriff des Patentanspruchs 1 gekennzeichneten Art zu schaffen, bei welchem die Abnahme des maximal abschaltbaren Stromes mit zunehmender Spannungsanstiegsgeschwindigkeit, d. h. mit abnehmender Kapazität des Snubber-Kondensators reduziert und bei fehlender Beschaltung eine Erhöhung des abschaltbaren Stromes und der Spannung, gegen die abgeschaltet werden darf, erzielt wird, ohne die n-Hauptbasiszone mit größerer Dicke auszulegen.

Diese Aufgabe wird durch das im Anspruch 1 gekennzeichnete Merkmal gelöst.

Vorteilhafte Weiterbildungen der Erfindung sind in den Unteransprüchen gekennzeichnet.

Durch die Erfindung werden folgende Vorteile erzielt:

Der maximal abschaltbare Strom nimmt mit steigender Spannungsanstiegsgeschwindigkeit dU/dt wesentlich weniger ab, bei gegebenem abschaltbaren Strom wird die zulässige Spannungsanstiegsgeschwindigkeit beim Abschalten erhöht, wodurch der Snubber-Kreis, auf den der Strom beim Abschalten des GTO-Thyristors kommutiert wird und der die Spannungsanstiegsgeschwindigkeit bestimmt, mit einem kleineren Kondensator bestückt werden kann. Dies hat zur Folge, daß sowohl die Abschaltverluste als auch die Einschaltverluste des Schalters (einschließlich der Verluste im Snubber) reduziert werden, wodurch sich eine Erhöhung der Frequenzgrenze ergibt, die wesentlich durch die Schaltverluste und damit die abzuführende Wärmemenge bestimmt ist. Besonders wichtig für die Anwendung ist, daß auch ganz ohne Snubber-Beschaltung relativ hohe Ströme gegen relativ hohe Spannungen abgeschaltet werden können. Ein weiterer Vorteil besteht darin, daß die beiden anodenseitigen p+-Emitterstreifen nunmehr mit einem größeren Abstand voneinander angeordnet werden können, ohne daß der maximal abschaltbare Strom durch den vorstehend genannten Effekt der Feldstärkeüberhöhung reduziert wird; durch eine derartige Verschiebung dieser p+-Emitterstreifen zum Gate G hin wird die Injektion der p+-Emitterzone beim Abschalten schneller unterbrochen, woraus ine Verringerung der Schweifzeit und Abschaltverluste sowie auch der Abschaltladung im Gatekreis resultiert.

Die Erfindung wird nachstehend anhand eines in der Zeichnung schematisch dargestellten Ausführungsbeispieles näher erläutert. Es zeigen

Fig. 1 eine Einheitszelle eines bekannten gateabschaltbaren Thyristors und den Verlauf der Raumladungszonen beim Abschalten,

Fig. 2 den Strom-und Spannungsverlauf am GTO-Thyristor ohne Snubber bei Abschalten einer induktiven Last,

Fig. 3 die Feldstärkeverteilungen beim Thyristor nach der Fig. 1,

Fig. 4 eine erfindungsgemäße Ausbildung der Einheitszelle eines gateabschaltbaren Thyristors,

Fig. 5 die Feldstärkeverteilung beim Thyristor nach der Fig. 4,

Fig. 6 eine andere erfindungsgemäße Ausbildung der Einheitszelle,

Fig. 7 eine weitere erfindungsgemäße Ausbildung der Einheitszelle.

Beim Abschalten von hohen Strömen gegen hohe Spannungen ergeben sich beim Thyristor nach der Fig. 1 bei induktiver Last und Betrieb ohne Parallel-Kondensator die aus der Fig. 2 ersichtlichen Strom-und Spannungsverläufe; wie ersichtlich, fällt der Strom J erst dann stark ab, nachdem die Spannung u schon den vollen äußeren Spannungswert erreicht hat. Die Spannung am Bauelement steigt also bei nahezu vollem Laststrom auf ihren maximalen Wert an.

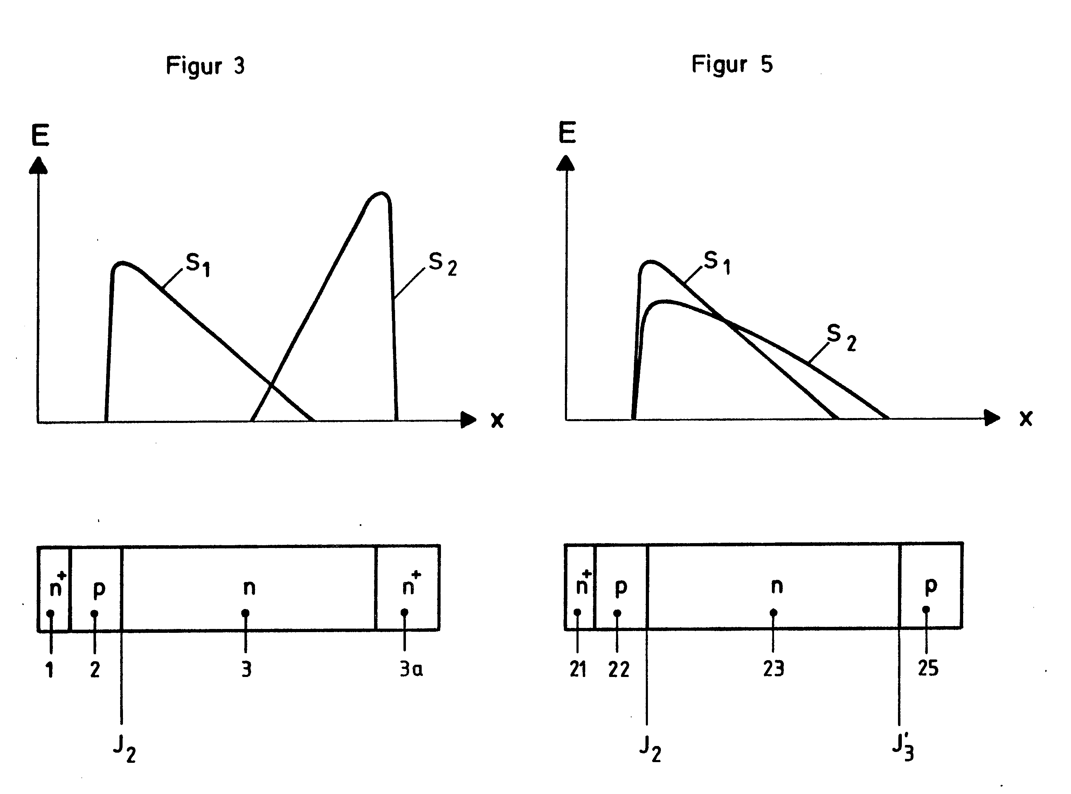

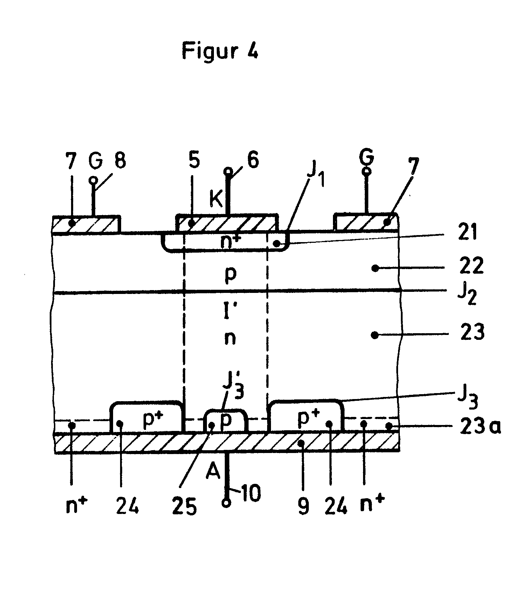

Wie aus dem Kurvenzug S1 nach der Fig. 3 ersichtlich, nimmt die Feldstärke E im abgeschalteten Zustand des GTO-Thyristors ihren maximalen Wert am pn-Übergang $J_2$ an; während des Abschaltens von hohen Stromen hat die Feldstärke E dagegen wegen der freien Elektronen am nn+-Übergang des nichtregenerativen Transistorbereichs I ihren Maximalwert, wie durch den Kurvenzug S2 dargestellt, der bei hohen Stromen wesentlich größer als die maximale Feldstärke nach dem Abschalten ist. Die Einheitszelle nach Fig. 4 weist wie die Einheitszelle nach Fig. 1 einen kathodenseitigen n+-Emitterstreifen 21, eine p-Steuerbasiszone 22, eine n-Hauptbasiszone 23 mit einer hoch dotierten n+-Teilzone 23a und zwei anodenseitige p+-Emitterstreifen 24 auf.

Zwischen den anodenseitigen p+-Emitterstreifen 24 ist nunmehr eine Zone 25 zur dynamischen Begrenzung des elektrischen Feldes angeordnet , die ebenfalls Löcher injiziert, jedoch in geringerem Maße und im wesentlichen nur während des Abschaltens von hohen Stromen. Die Breite dieser zusätzlichen p-Zone 25 ist wesentlich geringer als die der äußeren p+-Emitterstreifen 24. Wegen des Kurzschlusses des pn-Übergangs $J_3$ am Rand der p-Zone 25 durch die Kontaktierungsschicht 9 ist somit auch das Injektionsvermögen reduziert; und zwar wird die Emitterwirksamkeit durch Einstellen der Breite der p-Zone 25 so vermindert, daß der 4-Zonenbereich ohne Zuspeisung von den Seiten nicht eingeschaltet sein kann, d. h. daß $\alpha_{pnp} + \alpha_{pn} < 1$ ist, so daß dort in der Durchlaßphase wenig Strom fließt. Der Bereich I' zwischen den beiden p+-Emitterstreifen über der p-Zone 25 soll also wie beim Thyristor nach Fig. 1 nicht regenerativ sein.

Beim Abschalten unter den in Verbindung mit der Fig. 2 geschilderten Bedingungen schiebt sich die Raumladungszone in der n-Hauptbasiszone 23 infolge der Elektronen, welche die Raumladung der Donatoren $N_D+$ teilweise kompensieren, so nahe an die mittlere p-Zone 25 heran, daß diese nun Löcher injiziert. Der Abstand der Raumladungszone von der p-Zone 25 verringert sich solange, bis die Löcherinjektion der p-Zone 25 eine weitere Reduzierung der Raumladung und Aufweitung der Raumladungszone nicht mehr zuläßt. Zum Unterschied vom bekannten GTO-Thyristor nach Fig. 1 wird die Raumladung R also nicht negativ sondern sie wird nur schwächer positiv als bei stationärer Sperrbelastung.

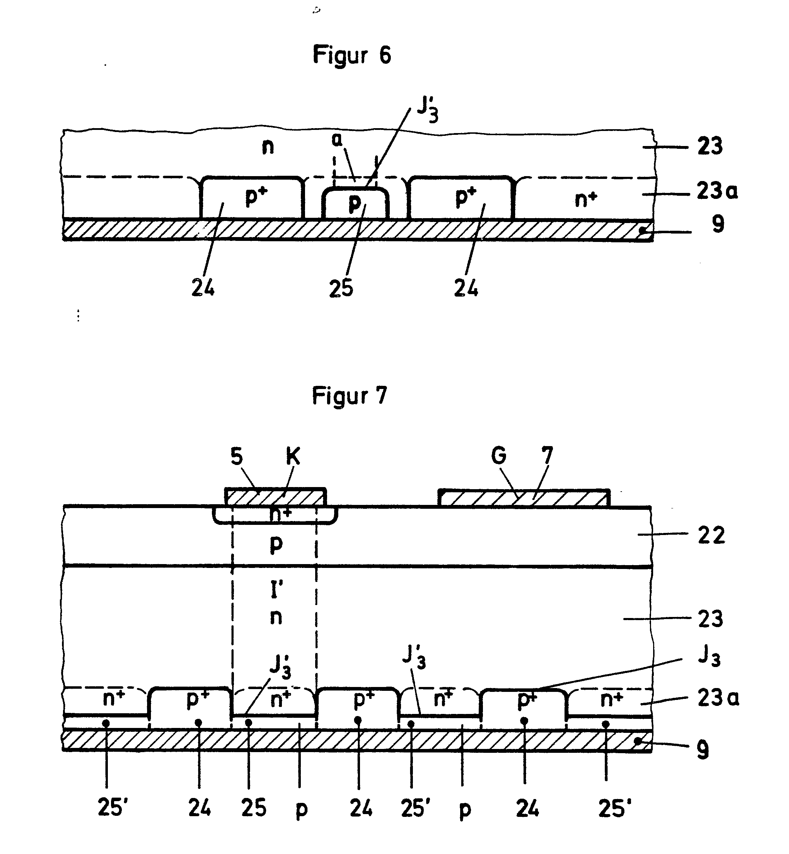

Wie aus dem Kurvenzug S2 nach der Fig. 5 ersichtlich, steigt die Feldstärke beim GTO-Thyristor nach der Fig. 4 von der Anodenseite zum mittleren pn-Übergang $J_2$ hin daher schwächer an als im stationären Fall (S1). Die Raumladungszone hat daher in dem Bereich I' eine größere Ausdehnung als in den benachbarten Bereichen; im Gegensatz zum bekannten Thyristor nach Fig. 1 bildet sie sich jedoch durchgehend um den pn-Übergang $J_2$. Die Injektionsfähigkeit der feldbegrenzenden p-Zone 25 kann außer durch deren Breite auch durch das Profil der Dotierungskonzentration festgelegt werden. Wird die Dotierungskonzentration geringer als bei den p+-Emitterstreifen 24 gewählt, so braucht man für die Einstellung der Emitterwirksamkeit der p-Zone 25. Die Breite nur weniger stark zu verkleinern, das hat Vorteile für die Herstellung, und die Löcherinjektio bei der Stromzusammenschnürung während des Abschaltens ist nicht auf eine zu geringe Fläche begrenzt. Die Breite der p-Zone 25 wird zweckmäßig zwischen 50 und 100 μm gewählt.

Eine andere Möglichkeit zur Reduzierung der effektiven Emitterwirksamkeit der p-Zone 25 besteht in der Heraufsetzung der Dotierungskonzentration der n-Basiszone 23 im Bereich vor der p-Zone 25. Wie in Fig. 6 dargestellt, kann die maximale Dotierungskonzentration $N'_{max}$ in einem Bereich der n-Basiszone 23 in einfacher Weise höhergewählt werden als vor dem $p^+$-Emitterstreifen 24, indem die Teilzone der n-Basiszone 23 und der p-Zone 25 durch Diffusion erzeugt werden und die Dicke der p-Zone 25 geringer als die der $n^+$-Teilzone 23a eingestellt wird. Durch die höhere maximale Dotierungskonzentration $N'_{max}$ ist der Querspannungsabfall in der n-Basiszone 23, der den pn-Übergang $J'_3$ zwischen p-Zone 25 und n-Basiszone 23 in Vorwärtsrichtung polt, geringer; das hat zur Folge, daß die Einsatzstromdichte $j_{om}$, die in dem mittleren Bereich I' über der p-Zone 25 erforderlich ist, damit die p-Zone 25 zu injizieren beginnt, bei sonst gleichen Bemessungen größer als im Fall der $p^+$-Emitterstreifen 24 ist. Auf diese Weise kann die Einsatzstromdichte $j_{om}$ besonders stark heraufgesetzt und damit sichergestellt werden, daß die p-Zone 25 zwar bei der Stromzusammenschnürung während des Abschaltens injiziert und die elektrische Feldstärke reduziert wird, daß aber der effektive Stromverstärkungsfaktor $\alpha_{pnp}$ dort auch bei hohen Stromdichten relativ klein und der Bereich I' nicht regenerativ bleibt und sich so leicht abschalten läßt.

Zweckmäßig wird die maximale Dotierungskonzentration $N'_{max}$ der hoch dotierten $n^+$-Teilzone 23a im Bereich vor der feldbegrenzenden p-Zone 25 zwischen etwa $3 \times 10^{15}/cm^3$ und etwa $1 \times 10^{17}/cm^3$ gewählt. Wird beispielsweise eine Dotierungskonzentration $N'_{max} = 5 \times 10^{16}/cm^3$ gewählt, so liegt die Einsatzstromdichte $j_{om}$ bei einer Breite der p-Zone 25 von etwa 70μm und anderen typischen Bemessungen und Dotierungsprofilen schon oberhalb etwa 3 000 A/cm². Wie die Fig. 7 zeigt, ist es auch möglich, die feldbegrenzende p-Zone 25 bis an die $p^+$-Emitterstreifen 24 auszudehnen, so daß kein anodenseitiger Emitter-Basiskurzschluß mehr besteht. In diesem Fall ist es zweckmäßig, die Dotierungskonzentration $N'_{max}$ der $n^+$-Teilzone 23a höher als bei der Ausbildung nach der Fig. 6 im Bereich a zu wählen, beispielsweise $5 \times 10^{17}/cm^3$. Durch diese hohe Dotierungskonzentration ist auch ohne Shortung der Stromverstärkungsfaktor $\alpha_{pnp}$ im Bereich I' gut reproduzierbar so einstellbar, daß die p-Zone 25 einerseits beim Abschalten von hohen Strömen genügend Löcher in die schwach dotierte n-Basiszone 23 injiziert, so daß das elektrische Feld reduziert wird, daß aber andererseits der Bereich Iμ über der p-Zone 25 nichtregenerativ und leicht abschaltbar ist.

Wie weiter in Fig. 7 angedeutet, können auch in den Bereichen unter der Gatekontaktierung 7 anodenseitige p-Zonen 25' angeordnet sein, die sich jeweils bis zu den $p^+$-Emitterstreifen 24 ausdehnen; dies ist herstellungstechnisch günstig, da für die Erzeugung der feldbegrenzenden p-Zone 25 und der p-Zone 25' nur eine unmaskierte zusätzliche Diffusion erforderlich ist. Da bei dieser Ausbildung die Anoden-Emitterkurzschlüsse fehlen und deren Funktion durch die gering injizierenden pn-Übergänge $J'_3$ nur zum Teil übernommen wird, muß der Halbleiterkörper zur Erzielung guter Schalteigenschaften zusätzlich mit lebensdauerreduzierenden Rekombinationszentren dotiert werden. Auch bei dieser Ausbildung ohne Anoden-Emitterkurzschlüsse wird gegenüber bekannten GTO-Thyristoren sowohl mit als auch ohne Anoden-Emitterkurzschlüssen eine Erhöhung des maximal abschaltbaren Stroms bei hoher Spannungsanstiegsgeschwindigkeit erzielt.

## Ansprüche

1. Abschaltbarer Thyristor mit einer npnp-Struktur, bei der die kathodenseitige n-Emitterzone in eine Vielzahl von Emitterstreifen aufgeteilt ist, denen jeweils zwei anodenseitige p-Emitterstreifen gegenüberliegen, die sich in ihrer Lage mit dem Rand des jeweiligen kathodenseitigen Emitterstreifens überlappen, mit einer p-Steuerbasiszone und einer n-Hauptbasiszone, die zur Anodenseite um wenigstens in Teilbereichen in eine höher dotierte $n^+$-Teilzone übergeht, **dadurch gekennzeichnet,** daß zwischen zwei, jeweils einem kathodenseitigen Emitterstreifen (21) gegenüberliegenden anodenseitigen Emitterstreifen (24) im Bereich einer $n^+$-Teilzone (23a) eine p-Zone (25) zur dynamischen Begrenzung des elektrischen Feldes angeordnet ist, die in geringerem Maß als die benachbarten Emitterstreifen (24) und im wesentlichen nur während des Abschaltens von hohen Strömen Löcher injiziert.

2. Thyristor nach Anspruch 1, **dadurch gekennzeichnet,** daß die feldbegrenzend p-Zone (25) ein von den p-Emitterstreifen (24) getrennte Zone bildet.

3. Thyristor nach Anspruch 2, **dadurch gekennzeichnet,** daß die Breite der feldbegrenzenden p-Zone (25) geringer als die der p-Emitterstreifen (24) ist.

4. Thyristor nach Anspruch 2,
**dadurch gekennzeichnet,**
daß die Dicke der feldbegrenzenden p-Zone (25) geringer als die der anodenseitigen hoch dotierten $n^+$-Teilzone (23a) der n-Basiszone (23) ist.

5. Thyristor nach Anspruch 4,
**dadurch gekennzeichnet,**
daß die maximale Dotierungskonzentration der hoch dotierten $n^+$-Teilzone (23a) in dem Bereich (a) vor der feldbegrenzenden p-Zone (25) größer als etwa $3 \times 10^{15}/cm^3$ und kleiner als etwas $1 \times 10^{17}/cm^3$ ist.

6. Thyristor nach Anspruch 1
**, dadurch gekennzeichnet,**
daß die feldbegrenzende p-Zone (25) sich bis zu den benachbarten p-Emitterstreifen (24) ausdehnt.

7. Thyristor nach Anspruch 6,
**dadurch gekennzeichet,**
daß die maximale Dotierungskonzentration der hoch dotierten $n^+$-Teilzone (23a) gleich oder größer als etwa $5 \times 10^{15}/cm^3$ ist.

8. Thyristor nach Anspruch 7,
**dadurch gekennzeichnet,**
daß in den Bereichen unter der Gatekontaktierung (7) eine anodenseitige p-Zone (25') angeordnet ist.

## Figur 1

## Figur 2

Figur 3

Figur 5

0 241 662

## Figur 4

0 241 662

## Figur 6

## Figur 7